# EUROPÄISCHE PATENTSCHRIFT

(11) **EP 1 083 658 B1**
(45) Veröffentlichungstag und Bekanntmachung des Hinweises auf die Patenterteilung: **14.02.2007**
(21) Anmeldenummer: 99126047.2
(22) Anmeldetag: 28.12.1999
(51) Int. Cl.: H03K 17/082

(54) **Schaltungsanordnung zur Überwachung eines zum Steuern einer Last vorgesehenen elektronischen Schalters**
Circuit arrangement for monitoring an electronic switch intended for controlling a load
Montage servant à la surveillance d'un commutateur électronique destiné à la commande d'une charge

(30) Priorität: 08.09.1999 DE 19942830
(43) Veröffentlichungstag der Anmeldung: 14.03.2001
(73) Patentinhaber: Melcher, Rolf, Dr.-Ing., 76133 Karlsruhe (DE); Seliger, Siegfried, Dipl.-Ing., 44149 Dortmund (DE)
(72) Erfinder: Melcher, Rolf, Dr.-Ing., 76133 Karlsruhe (DE); Seliger, Siegfried, Dipl.-Ing., 44149 Dortmund (DE)
(74) Vertreter: Hilleringmann, Jochen

(56) Entgegenhaltungen:
- WO-A-98/10301
- US-A- 4 945 445
- US-A- 5 804 979

## Beschreibung

Die Erfindung bezieht sich auf eine Überwachungs- und Strommeß-Einheit für MOSFET-Transistoren in Lowside (LS) und/oder Highside (HS) Konfiguration mit jedweder elektrischer Last, insbesondere induktiver Last. Die der Erfindung zugrundeliegende Aufgabenstellung besteht in der präzisen Erfassung des Stroms durch den Transistor und in der Detektion fehlerhafter Zustände allein durch Beobachtung des Spannungsverlaufs der Drain-Source-Spannung an einem HS- und LS-Transistor zum Treiben einer Last.

Die beschriebene Erfindung könnte beispielsweise in einem Spulentreiber eines elektromagnetischen Ventils eingesetzt werden. Der Spulentreiber kann hierbei als LS- Schalter und/oder HS-Schalter ausgeführt sein. Andere mögliche Anwendungen sind MOSFET-Brückenschaltung zur Ansteuerung von gepulsten DC-Motoren, Schrittmotoren oder Asynchronmotoren. Eine präzise Erfassung des Strom-Spannungs-Verlaufs ist zur Realisierung einer Stromregelung sowie zur Fehlerdiagnose erforderlich. Mit einer z.B. integrierten Schaltung (ASIC) zur Ansteuerung einer aus externer Leistungshalbleitern vom Typ Feldeffekttransistor gebildeten Halb-/Vollbrücke können durch die oben beschriebene Anordnung auftretende Laststromspitzen und die innere Erwärmung der Leistungsschalter durch die genaue Bestimmung des RDSon-Widerstandes und der Schalterspannung überwacht werden.

Zur Realisierung der beschriebenen Funktionalität wird heute bei Lastansteuerungen mit diskreten Leistungs-MOSFETS hauptsächlich ein Messverfahren basierend auf Spannungsmessung über einem Shunt-Widerstand im Laststromkreis angewendet (siehe z. B. US-A-4 967 309 und US-A-4 820 968). Die Ansteuerung dieser diskreten Leistungs-MOSFETS erfolgt heute mit ICs basierend auf spannungsfesten BCD- und CMOS-Prozessen. Bei hohen Lastströmen ist es nicht wirtschaftlich, den Shunt-Widerstand im Ansteuerungsbaustein zu integrieren. Daher werden auch Leistungs-MOSFETS eingesetzt, die einen Sense-Strom-Ausgang besitzen, über den ein Teil des Laststroms angekoppelt wird. Dann kann dieser Widerstand im Ansteuerungsbaustein integriert werden, wodurch externe Bauelemente eingespart werden können. Dieser Vorteil wird erkauft durch einen höheren funktionalen Aufwand für die diskreten Leistungs-MOSFETS. Bei voll integrierten LS/HS-Schalterkonfigurationen auf der Basis junction-isolierter BCD-Prozesse oder CMOS-Prozesse ist der Mehraufwand unbedeutend. Nachteilig ist hier, dass die Leistungs-MOSFETS gegenüber diskreten Transistoren mit einem relativ aufwendigen Prozess hergestellt werden, so dass diese Lösung aber einer bestimmten Stromstärke nicht mehr wirtschaftlich ist. Eine Strommessung beispielsweise in einer Motorbrücke bestehend aus diskreten Leistungs-MOSFETS ohne Shunt-Widerstände auf der Basis des Spannungsabfalls über der Drain-Source-Strecke ist daher wünschenswert. Da der Transistor-Einschaltwiderstand einer relativ großen Exemplarstreuung, Temperaturabhängigkeit und Alterungsdegradation unterliegt, ist diese Messung jedoch sehr ungenau und somit nur unzureichend für eine Regelung oder Überwachung z.B. einer Motorbrücke geeignet. Kalibrierungsmethoden basierend auf Eichkurven des Einschaltwiderstands in Abhängigkeit der Temperatur sind aufwendig und teuer.

Aus DE-A-197 43 346 ist eine Schaltungsanordnung zur getakteten Stromregelung von induktiven Lasten bekannt, bei der parallel zur Last eine Freilaufdiode mit Strommesseinrichtung geschaltet ist. Bei dieser Schaltungsanordnung kann auf einen Shunt-Widerstand verzichtet werden, da die Strommessung ausschließlich während des AUS-Zustandes der die Last schaltenden Schalteinrichtung erfolgt.

Schließlich ist aus DE-A-197 36 752 eine weitere Schaltungsanordnung zum Schutz einer Treiberschaltung bekannt, bei der die über einem Treiber-Feldeffekttransistor abfallende Spannung gemessen und von einem Mikroprozessor ausgewertet wird. Die Ermittlung des Laststroms setzt bei dieser Schaltungsanordnung die Kenntnis des Innenwiderstandes des Feldeffekttransistors voraus. Dieser Innenwiderstand ist jedoch über den Arbeitsbereich des Feldeffekttransistors nicht konstant, weshalb die bekannte Schaltungsanordnung recht ungenau misst und nur bedingt dem Schutz der Treiberschaltung dienen kann.

US 5804979 offenbart eine Schaltung bei der ebenfalls die Impedanz eines resistiven Bauteiles gemessen werden kann. Diese Schaltung arbeitet mit einem Modulationsstrom und einem Spannungsmesser der über einen Schalter entweder den Spannungsabfall aufgrund des Laststromes misst bzw. den Spannungsabfall hervorgerufen durch den Modulationsstrom.

Der Erfindung liegt die Aufgabe zugrunde, eine Schaltungsanordnung zum Überwachen eines zum Steuern einer Last vorgesehenen und von einem Laststrom zum Treiben der Last durchflossenen elektronischen Schalters, die keinerlei Veränderungen an dem elektronischen Schalter erfordert und ohne die Verwendung eines Shunt-Widerstandes auskommt.

Zur Lösung dieser Aufgabe wird mit der Erfindung eine Schaltungsanordnung zur Überwachung eines zum Steuern einer Last vorgesehenen und innerhalb von Einschaltintervallen von einem Laststrom zum Treiben der Last durchflossenen elektronischen Schalters vorgeschlagen, der in einem Teilbereich seines Einschaltzustandes ein im wesentlichen lineares Widerstandsverhalten aufweist und dessen Arbeitspunkt beim Steuern der Last in diesem Teilbereich des Einschaltzustandes liegt, wobei die Schaltungsanordnung erfindungsgemäß versehen ist mit
- einem Modulationssignalgenerator zum Erzeugen eines den durch den elektronischen-Schalter fließenden Laststrom modulierenden Modulationssignals,
- einer erste Spannungsmessvorrichtung zum Messen des auf das Modulationssignal zurückzuführenden ersten Spannungsabfalls über dem elektronischen Schalter,
- einer zweiten Spannungsmessvorrichtung zum Messen des auf den Laststrom zurückzuführenden Spannungsabfalls über dem elektronischen Schalter und
- einer Auswerteeinheit, die anhand des Modulationssignals sowie des ersten und des zweiten Spannungsabfalls den Laststrom ermittelt.

Die vorliegende Erfindung geht von einer aus Leistungs-MOSFETS bestehenden Lowside/Highside-(LS/HS-)Schalterkonfiguration mit beispielsweise induktiver Last aus und hat die Realisierung einer Schaltung zur Laststrommessung auf der Basis der Drain-Source-Spannung der MOSFET-Schalter zum Gegentand. Kern der Erfindung ist die Rückführung der Strommessung auf eine Bestimmung des differentiellen Einschaltwiderstands der aktiven LS/HS-Transistoren. Der differentielle Widerstand des eingeschalteten Transistors lässt sich bestimmen, indem die durch eine bekannte Veränderung des den Schalter durchfließenden Stroms (Modulation des Strom) hervorgerufene Drain-Source-Spannungsänderung gemessen wird. Befindet sich der Transistor in einem näherungsweise linearen Arbeitsbereich, d.h. dass die Differenz aus Gate-Source-Spannung und Schwellenspannung größer ist als die Drain-Source-Spannung, sind der differentielle Einschaltwiderstand und der Absolutwert des Einschaltwiderstands identisch. Somit kann der gesuchte Laststrom aus dem Absolutwert der Drain-Source-Spannung und dem differentiellen Einschaltwiderstand bestimmt werden.

Nach der Erfindung ist es nicht zwingend erforderlich, den differentiellen Einschaltwiderstand separat zu bestimmen. Für die Ermittlung des Laststroms dient der differentielle Einschaltwiderstand lediglich als Zwischengröße, die nicht notwendigerweise als Wert von der Auswerteeinheit geliefert werden muß. Es reicht vielmehr aus, wenn die Auswerteeinheit durch entsprechende Verrechnung des Modulationssignals und der ersten sowie der zweiten Spannungsabfälle nach dem Ohmschen Gesetz die (momentane) Größe des Laststroms ermittelt.

Sofern für Überwachungszwecke die Kenntnis des momentanen Einschaltwiderstandes des elektronischen Schalters erforderlich ist, kann dieser von der Auswerteeinheit anhand des Modulationssignals und des ersten Spannungsabfalls, also anhand des durch die Modulation des Laststroms hervorgerufenen Spannungsabfalls über dem Einschaltwiderstand ermittelt werden.

Anhand einer im vorhinein erfolgten Kalibrierung des elektronischen Schalters kann dessen Temperaturveränderung in Abhängigkeit von der Veränderung des Einschaltwiderstandes ermittelt werden. Durch die Ermittlung des Einschaltwiderstandes lässt sich dann in der Auswerteeinheit auch auf die momentane Temperatur des elektronischen Schalters schließen.

Im Regelfall wird es sich bei dem elektronischen Schalter um einen Feldeffekttransistor, insbesondere um einen MOSFET handeln.

Das Modulationssignal, bei dem es sich insbesondere um einen in die Verbindungsleitung zwischen dem elektronischen Schalter und der Last eingespeisten und/oder aus diesem Knotenpunkt "gezogenen" Messstrom handelt, fließt in Abhängigkeit von dem Verhältnis der Impedanzen der Last und des elektronischen Schalters über diese beiden Komponenten. Sofern die Impedanz (EIN-Widerstand) des elektronischen Schalters im Arbeitspunkt vernachlässigbar gegenüber der Impedanz der Last ist, kann der über die Last abfließende Anteil des Messstroms bei der Ermittlung in der Auswerteeinheit vernachlässigt werden. Aus Vereinfachungsgründen wird also dann in der Auswerteeinheit mit dem von der Messstromerzeugungsvorrichtung erzeugten Messstrom gearbeitet. Dieser Messstrom ist grundsätzlich bekannt, und lässt sich beispielsweise aus dem Ansteuerungssignal des Modulationssignalgenerators ermitteln, bei dem es sich in diesem Fall um eine Stromquelle handelt.

Sollte hingegen die Impedanz des elektronischen Schalters nicht vernachlässigbar gegenüber der Impedanz der Last sein, so ist bei bekannter Impedanz der Last der über den elektronischen Schalter abfließende Anteil des Messstroms ermittelbar, so dass in der Auswerteeinheit dieser über den elektronischen Schalter fließende Anteil des Messstroms in die Ermittlungen eingeht.

Mit Hilfe der erfindungsgemäßen Vorrichtung lässt sich also, wie oben beschrieben, während eines Einschaltintervalls der über den geschlossenen elektronischen Schalter fließende Strom, der auch über die Last selbst fließt, ermitteln. Bei ausgeschaltetem elektronischen Schalter fließt kein Laststrom durch die Last, da der geöffnete Schalter die Verbindung der Last mit der Betriebsspannungsquelle unterbricht. Wird in diesem Fall weiterhin ein Modulationssignal für den nicht fließenden Laststrom erzeugt, so fließt letztendlich durch die Last ein Strom, der weiter oben auch mit Messstrom bezeichnet ist. Bei geöffnetem Schalter fließt dieser Messstrom durch die Last. Sofern die Lastimpedanz unbekannt, jedoch im wesentlichen linear und insbesondere konstant ist, kann anhand des Messstroms und des ersten Spannungsabfalls die augenblickliche Impedanz der Last ermittelt werden. Sofern die Versorgungsspannung bekannt ist, geht diese in die Ermittlung der Impedanz ein; diese Versorgungs- bzw. Betriebsspannung kann aber auch während derjenigen Intervalle, in denen kein auf das Modulationssignal zurückzuführender Strom durch die Last fließt, durch Messung des zweiten Spannungsabfalls ermittelt werden. Durch diese Impedanzermittlung der Last kann letztendlich eine erhöhte Messgenauigkeit der erfindungsgemäßen Schaltungsanordnung erzielt werden, indem nämlich die im Ausschaltzustand des Schalter ermittelte Impedanz der Last bei der anschließenden Laststromermittlung bei geschlossenem Schalter zu Hilfe genommen wird.

Nachfolgend wird die Erfindung anhand der Zeichnung näher erläutert. Im einzelnen zeigen:
- Fign. 1 und 2:: Ausführungsbeispiele der erfindungsgemäßen Schaltungsanordnung in der Anwendung zur Überwachung der Highside- und Lowside-Schalter einer Motor-Brückenansteuerungsschaltung und
- Fign. 3 und 4:: Ausführungsbeispiele der erfindungsgemäßen Schaltungsanordnung bei Anwendung für als Highside- bzw. Lowside-Schalter fungierenden elektronischen Schaltern.

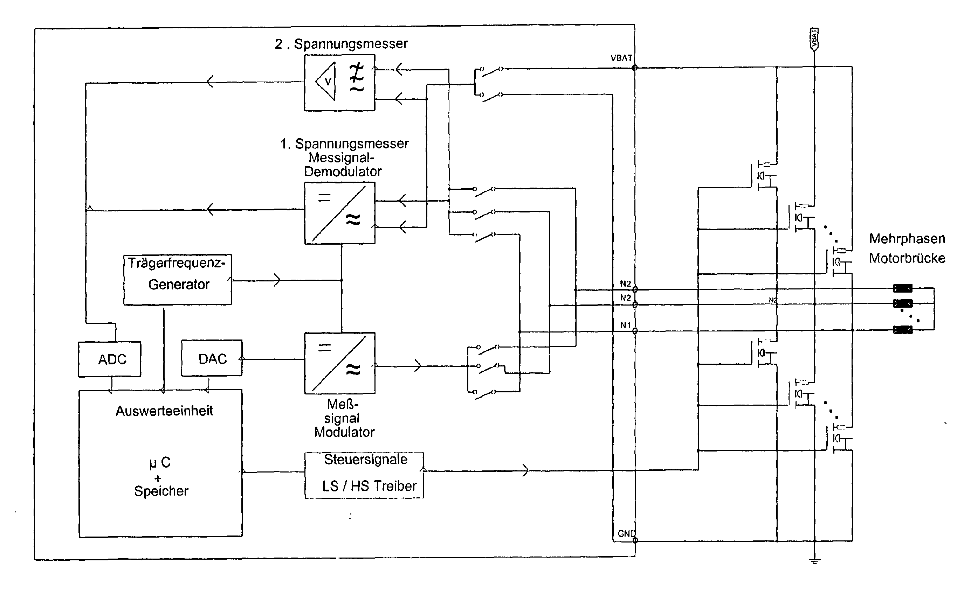

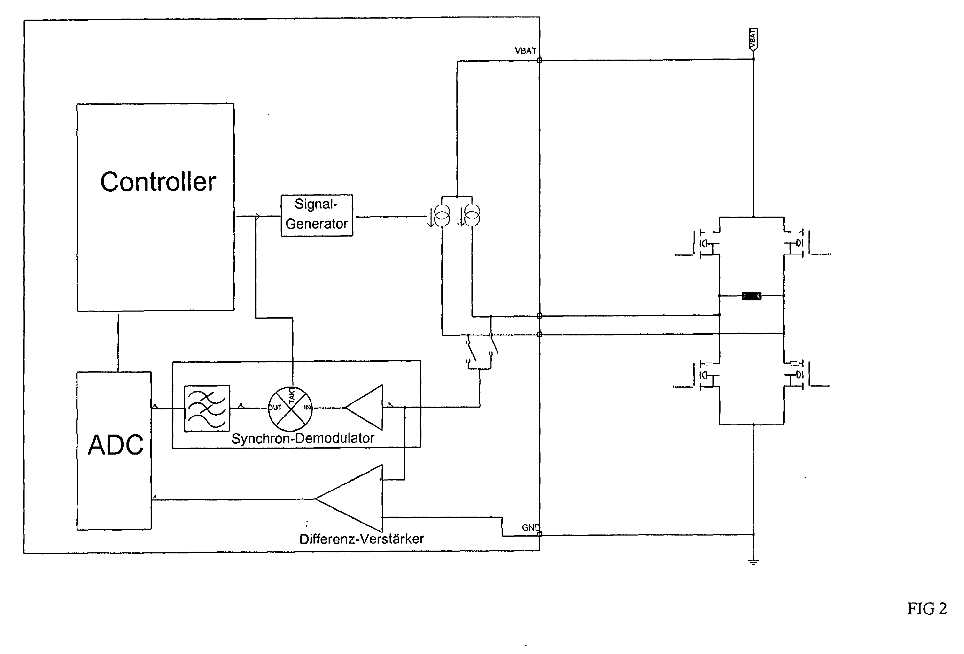

Eine erfindungsgemäße Ausführung dieser Funktion wird z.B. mit Hilfe eines Strommodulators und synchroner Spannungsdemodulation entsprechend Fig. 1 oder Fig. 2 realisiert. Der Messstrom mit der Amplitude I_{REF} und der Frequenz ω wird entsprechend Fig. 1 oder Fig. 2 in den Mittelabgriff zwischen Transistor und Induktivität eingespeist. Die vom Messstrom hervorgerufene Spannungsänderung über der Drain-Source-Strecke des eingeschalteten Transistors wird anschließend wieder mit einem Synchrondemodulator zurückgewonnen. Die auf diese Weise ermittelte Spannungsamplitude U_{d} zusammen mit der Amplitude des eingeprägten Referenzstroms (I_{REF}) ermöglicht die Bestimmung des differentiellen Transistor-Einschaltwiderstands R_{Diff}. Mit Hilfe des DC-Wertes der Drain-Source-Spannung und des ermittelten Widerstands R_{Diff} ist es nun möglich, den Laststrom zu bestimmen.

Die Erfindung ist also in einer Schaltungsanordnung zur Bestimmung von Messgrößen wie Z, U, I einer Schalteranordnung mit einer beliebigen Lastanordnung mit Hilfe der Source-Drain-Strecke eines Feldeffekttransistors mit im leitenden Zustand linearem Widerstandsverhalten zu sehen, die über eine Vorrichtung mit einem ersten Anschlusspunkt zwischen der beliebigen Lastanordnung und dem Source- oder Drain-Anschluß des Feldeffekttransistors verfügt, einen Messstrom, der sich in Frequenz- und/oder Signalform vom Laststrom unterscheidet, einspeisen oder abführen kann, und desweiteren über eine erste Messschaltung mit einem zweiten Anschlusspunkt beispielsweise an der Source- oder Drain-Elektrode und einem dritten Anschlusspunkt beispielsweise an der Drain- oder Source-Elektrode verfügt, die nur auf durch den eingespeisten oder abgeführten Messstrom hervorgerufene Spannungsänderungen reagiert, sowie eine zweite Messschaltung beinhaltet, die den durch den Laststrom bewirkten Spannungsabfall beispielsweise an der Schalteranordnung misst, und zwar dergestalt, dass bei bekanntem Messstrom der Vorrichtung am ersten Anschlusspunkt die Messspannung der ersten Messschaltung die genaue Bestimmung der Impedanz der Schalteranordnung gestattet und gemeinsam mit der Spannungsmessung der zweiten Anordnung die Bestimmung des Stroms durch die Schalteranordnung bei beliebiger Last ermöglicht. Aufgrund eines Messsignals (Messstrom), das erfindungsgemäß dem zu überwachenden Feldeffekttransistor-Laststrom überlagert ist, können Informationen über den aktuellen Einschalt-Widerstand des Transistors gewonnen werden. Diesbezüglich hilfreich ist das lineare Widerstandsverhalten des Transistors. Der Transistor dient sozusagen als Shunt-Widerstand, so dass auf einen separaten Shunt- bzw. Messwiderstand erfindungsgemäß verzichtet werden kann.

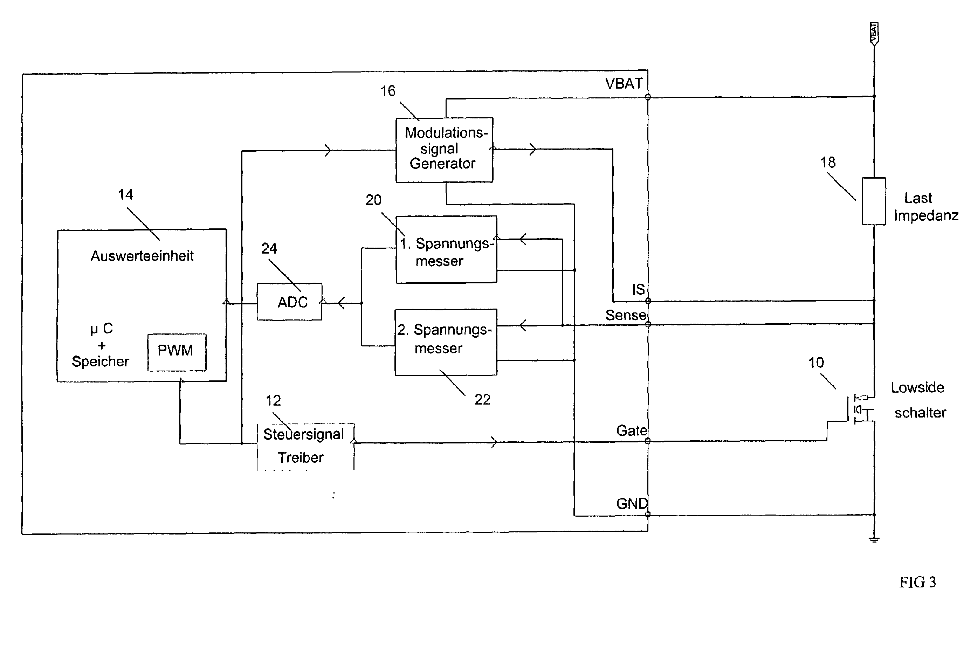

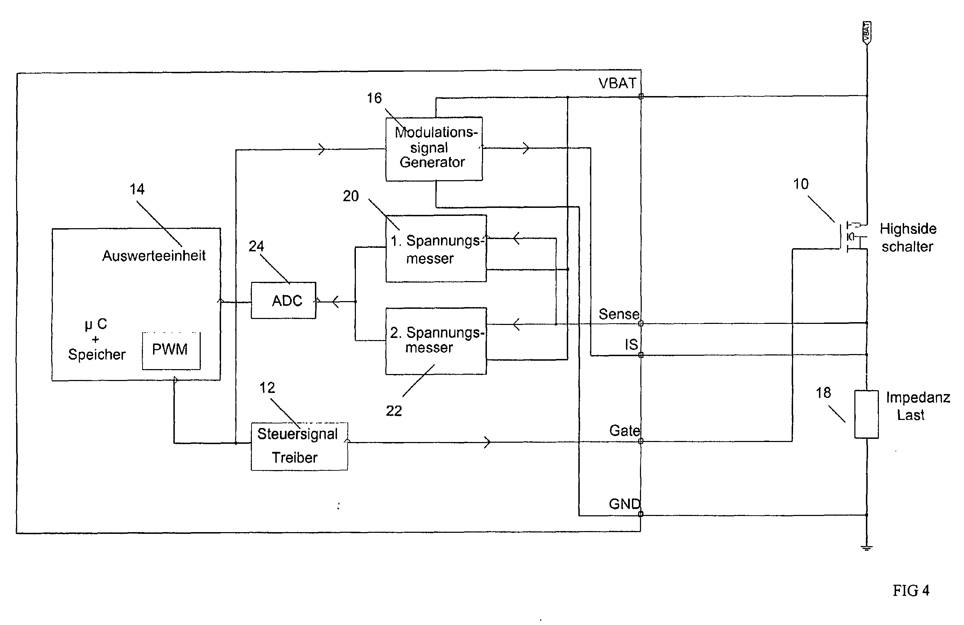

Fign. 3 und 4 zeigen die Verwendung der erfindungsgemäßen Schaltungsanordnung zur Überwachung eines als Lowside- bzw. Highside-Schalters eingesetzten MOSFET. Bei diesem Ausführungsbeispiel ist das Modulationssignal ein dem Laststrom überlagerter Messstrom.

Der MOSFET 10 wird von einem Steuersignal-Treiber 12 angesteuert, der wiederum von einer Auswerteeinheit 14 in Form eines Mikroprozessors angesteuert wird. Diese Auswerteeinheit 14 steuert auch einen Messsignalgenerator 16 an, der einen AC-Messstrom erzeugt und diesen in den Knoten zwischen dem MOSFET 10 und der Last 18 einspeist. Der über dem MOSFET 10 entstehende Spannungsabfall wird einer ersten Spannungsmessvorrichtung 20 und einer zweiten Spannungsmessvorrichtung 22 zugeführt. Die erste Spannungsmessvorrichtung 20 ermittelt dabei denjenigen Spannungsabfallanteil, der durch den Messstrom hervorgerufen wird, während die zweite Spannungsmessvorrichtung 22 den von dem Laststrom herrührenden Spannungsabfall über dem MOSFET 10 ermittelt. Die Ausgangssignale beider Spannungsmessvorrichtungen werden über einen AD-Wandler 24 der Auswerteeinheit 14 zugeführt, die, wie oben näher beschrieben, falls gewünscht, aus der Größe des Messstroms und dem Ausgangssignal der Spannungsmessvorrichtung 20 den differentiellen Einschaltwiderstand des MOSFET 10 ermittelt bzw. aus der Größe des Messstroms und den Ausgangssignalen der Spannungsmessvorrichtungen 20,22 direkt den aktuellen Laststrom nach dem Ohmschen Gesetz ermittelt. Darüber hinaus kann die Auswerteeinheit 14 auch die aktuelle Temperatur des MOSFET 10 ermitteln, und zwar anhand des aktuellen Einschaltwiderstandes, der entsprechend einer zuvor erfolgten Kalibrierung ein Maß für die Temperatur des MOSFET 10 ist.

Die vorstehende Beschreibung der Fign. 3 und 4 setzt voraus, dass die Impedanz des MOSFET 10 im Einschaltzustand vernachlässigbar gegenüber der Impedanz der Last 18 ist. Ist dies nicht der Fall, so muß aus dem Verhältnis der Impedanzen der über den MOSFET 10 fließende Anteil des Messstroms für die Berechnungen in der Auswerteeinheit 10 zugrunde gelegt werden.

Wie vorstehend beschrieben, kann es sich bei dem Modulationssignalgenerator um eine Sinusquelle handeln, die kontinuierlich oder zeitweise das Modulationssignal erzeugt und auf die Schaltung gibt. Nachdem der Laststrom moduliert wird, handelt es sich bei der ersten Spannungsmessvorrichtung letztendlich um einen Demodulator, der durch Demodulation seines Eingangswerts letztendlich den auf die Modulation zurückzuführenden Spannungsabfall über der Last misst. Der Modulationssignalgenerator und der Demodulator der ersten Spannungsmessvorrichtung sind vorteilhafterweise synchron zueinander. Während die Sinusquelle insbesondere zur Realisierung eines kontinuierlichen Modulationssignals verwendet wird, kann zur Realisierung seines zeitdiskreten Modulationssignals eine Pulsquelle als Modulationssignalgenerator verwendet werden. Auch in diesem Fall handelt es sich bei der ersten Spannungsmessvorrichtung um einen Demodulator, wobei die Pulsquelle und der Demodulator wiederum zweckmäßigerweise synchron geschaltet sind.

Die schaltungstechnische Realisierung des Modulationssignalgenerators kann beispielsweise dergestalt sein, dass parallel zur Last eine Stromquelle geschaltet ist. Bei einer derartigen Schaltungsanordnung ist die Dynamik des Modulationssignals unabhängig vom Betrag des Laststroms. Wird dagegen der Modulationssignalgenerator mit einem steuerbaren Widerstand, der parallel zum elektronischen Schalter liegt, versehen, so ist die Dynamik des Modulationssignals linear abhängig vom Laststrom, die Modulation hingegen jedoch verlustleistungsarm.

Insgesamt gilt für sämtliche hier beschriebenen Fälle, dass die Modulation/Demodulation des Laststroms entweder zeitkontinuierlich oder zeitdiskret erfolgen kann. Dies hängt ganz vom konkreten Anwendungsfall ab.

Was die Auswerteeinheit betrifft, so sind in den hier beschriebenen Ausführungsbeispielen der Erfindung jeweils Mikroprozessoren, also digitale Schaltungen angegeben. Es ist aber auch ebenso möglich, die Auswerteeinheit durch eine analog arbeitende Schaltung zu realisieren. Hier sind Vorteile bezüglich des Platzbedarfs für diese analoge Schaltung zu erwarten. Die Auswertung erfolgt entweder anhand der Momentanwerte der beiden Spannungsabfälle und des Modulationssignals und/oder anhand der Amplitude des Modulationssignals bzw. der Spannungsabfälle. Wird über mehrere Zyklen gemessen, so kann der Laststrom als Mittelwert des pro Zyklus ermittelten Laststroms ermittelt werden.

## Patentansprüche

1. Schaltungsanordnung zur Überwachung eines zum Steuern einer Last vorgesehenen und innerhalb von Einschaltintervallen von einem Laststrom zum Treiben der Last durchflossenen elektronischen Schalters, der in einem Teilbereich seines Einschaltzustandes ein im wesentlichen lineares Widerstandsverhalten aufweist und dessen Arbeitspunkt beim Steuern der Last in diesem Teilbereich des Einschaltzustandes liegt, wobei die Schaltungsanordnung versehen ist mit
- einem Modulationssignalgenerator (16) zum Erzeugen eines den durch den elektronischen Schalter fließenden Laststrom modulierenden Modulationssignals,
- einer erste Spannungsmessvorrichtung (20) zum Messen des auf das Modulationssignal zurückzuführenden ersten Spannungsabfalls über dem elektronischen Schalter (10),
- einer zweiten Spannungsmessvorrichtung (22) zum Messen des auf den Laststrom zurückzuführenden Spannungsabfalls über dem elektronischen Schalter (10) und
- einer Auswerteeinheit (14), die anhand des Modulationssignals sowie des ersten und des zweiten Spannungsabfalls den Laststrom ermittelt.

2. Schaltungsanordnung nach Anspruch 1, **dadurch gekennzeichnet, dass** die Auswerteeinheit (14) anhand des Modulationssignals und des ersten Spannungsabfalls den Einschaltwiderstand des elektronischen Schalters (10) ermittelt.

3. Schaltungsanordnung nach Anspruch 2, **dadurch gekennzeichnet, dass** die Auswerteeinheit (14) anhand des ermittelten Einschaltwiderstandes des elektronischen Schalters (10) dessen Temperatur ermittelt.

4. Schaltungsanordnung nach einem der Ansprüche 1 bis 3, **dadurch gekennzeichnet, dass** der elektronische Schalter (10) ein Feldeffekttransistor, insbesondere ein MOSFET, ist.

5. Schaltungsanordnung nach einem der Ansprüche 1 bis 4, **dadurch gekennzeichnet, dass** die Auswerteeinheit (14) dann, wenn die Impedanz des elektronischen Schalters (10) im Arbeitspunkt vernachlässigbar gegenüber der Impedanz der Last (18) ist, den Laststrom und/oder den Einschaltwiderstand des elektronischen Schalters (10) anhand des von dem Modulationssignalgenerator (16) erzeugten Modulationssignals ermittelt.

6. Schaltungsanordnung nach einem der Ansprüche 1 bis 4, **dadurch gekennzeichnet, dass** die Auswerteeinheit (14) dann, wenn die Impedanz des elektronischen Schalters (10) im Arbeitspunkt bekannt und nicht vernachlässigbar gegenüber der Impedanz der Last (18) ist, den Laststrom und den Einschaltwiderstand des elektronischen Schalters (10) anhand des entsprechend der Impedanz der Last korrigierten Modulationssignals ermittelt.

7. Schaltungsanordnung nach einem der Ansprüche 1 bis 6, **dadurch gekennzeichnet, dass** die Auswerteeinheit (14) außerhalb eines Einschaltintervalls anhand des ersten und des zweiten Spannungsabfalls und des Modulationssignals die Impedanz der Last ermittelt, sofern diese unbekannt, jedoch die Impedanz des elektronischen Schalters (10) im Arbeitspunkt der Last vernachlässigbar gegenüber der Impedanz der Last ist und die Impedanz der Last näherungsweise lineares Verhalten aufweist, insbesondere näherungsweise konstant ist.

## Claims

1. A circuit arrangement for monitoring and controlling an electronic switch provided for controlling a load and flown through during turn-on intervals by a load current for driving the load, the switch having a substantially linear resistance behavior during parts of its turn-on state and the operating point of the switch being located in this part of the turn-on state during the load control, the circuit arrangement comprising:
- a modulation signal generator (16) for generating a modulation signal modulating the load current flowing through the electronic switch,
- a first voltage measuring device (20) for measuring the first voltage drop across the electronic switch (10) caused by the modulation signal,
- a second voltage measuring device (22) for measuring the voltage drop across the electronic switch (10) caused by the load current, and
- an evaluation unit (14) determining the load current from the modulation signal and the first and second voltage drops.

2. The circuit arrangement of claim 1, wherein the evaluation unit (14) determines the turn-on resistance of the electronic switch (10) from the modulation signal and the first voltage drop.

3. The circuit arrangement of claim 2, wherein the evaluation unit (14) determines the temperature of the electronic switch (10) from the turn-on resistance of the switch as determined.

4. The circuit arrangement of one of claims 1 to 3, wherein the electronic switch (10) is a field effect transistor, in particular a MOSFET.

5. The circuit arrangement of one of claims 1 to 4, wherein, when the impedance of the electronic switch (10) at the operating point is negligible with respect to the impedance of the load (18), the evaluation unit (14) determines the load current and/or the turn-on resistance of the electronic switch (10) from the modulation signal generated by the modulation signal generator (16).

6. The circuit arrangement of one of claims 1 to 4, wherein, when the impedance of the electronic switch (10) at the operating point is known and is not negligible with respect to the load of the impedance (18), the evaluation unit (14) determines the load current and the turn-on resistance of the electronic switch (10) from the modulation signal as corrected by the impedance of the load.

7. The circuit arrangement of one of claims 1 6, wherein, outside a turn-on interval of the switch, the evaluation unit (14) determines the impedance of the load from the first and second voltage drops and the modulation signal, if the impedance of the load is unknown but the impedance of the electronic switch (10) at the operating point of the load is negligible with respect to the impedance of the load and the impedance of the load has an approximately linear, in particular an approximately constant behavior.

## Revendications

1. Circuit pour la surveillance d'un commutateur électronique destiné à la commande d'une charge et traversé, à l'intérieur d'intervalles de déblocage, par un courant pour la charge destiné à exciter la charge, commutateur électronique qui présente une allure de variation sensiblement linéaire de sa résistance, dans une plage partielle de son état débloqué, et dont le point de fonctionnement, lorsqu'il commande la charge, se situe dans cette plage partielle de l'état débloqué, le circuit étant pourvu
- d'un générateur de signal de modulation (16) destiné à produire un signal de modulation modulant le courant pour la charge qui circule à travers le commutateur électronique,
- d'un premier dispositif de mesure de tension (20) destiné à mesurer la première chute de tension aux bornes du commutateur électronique (10), devant être ramenée sur le signal de modulation,
- d'un deuxième dispositif de mesure de tension (22) destiné à mesurer la chute de tension aux bornes du commutateur électronique (10), devant être ramenée sur le courant pour la charge, et
- une unité d'exploitation (14), qui détermine le courant pour la charge à partir du signal de modulation ainsi que de la première et de la deuxième chute de tension.

2. Circuit selon la revendication 1, **caractérisé en ce que** l'unité d'exploitation (14) détermine la résistance à l'état débloqué du commutateur électronique (10) à partir du signal de modulation et de la première chute de tension.

3. Circuit selon la revendication 2, **caractérisé en ce que** l'unité d'exploitation (14) détermine la température du commutateur électronique (10) à partir de sa résistance à l'état débloqué, qui a été déterminée.

4. Circuit selon l'une des revendications 1 à 3, **caractérisé en ce que** le commutateur électronique (10) est un transistor à effet de champ, en particulier un MOSFET.

5. Circuit selon l'une des revendications 1 à 4, **caractérisé en ce que** l'unité d'exploitation (14), lorsque l'impédance du commutateur électronique (10), au point de fonctionnement, est négligeable par rapport à l'impédance de la charge (18), détermine le courant pour la charge et/ou la résistance à l'état débloqué du commutateur électronique (10) à partir du signal de modulation produit par le générateur de signal de modulation (16).

6. Circuit selon l'une des revendications 1 à 4, **caractérisé en ce que** l'unité d'exploitation (14), lorsque l'impédance du commutateur électronique (10), au point de fonctionnement, est connue et non négligeable par rapport à l'impédance de la charge (18), détermine le courant pour la charge et la résistance à l'état débloqué du commutateur électronique (10) à partir du signal de modulation corrigé en correspondance avec l'impédance de la charge.

7. Circuit selon l'une des revendications 1 à 6, **caractérisé en ce que** l'unité d'exploitation (14), à partir de la première et de la deuxième chute de tension et du signal de modulation, détermine, à l'extérieur d'un intervalle de déblocage, l'impédance de la charge, dans la mesure où celle-ci est inconnue, mais que l'impédance du commutateur électronique (10), au point de fonctionnement de la charge, est négligeable par rapport à l'impédance de la charge et que l'impédance de la charge présente une allure de variation approximativement linéaire, en particulier est approximativement constante.
